Europäisches Patentamt

European Patent Office

Office européen des brevets

(11) Publication number: **0 425 095 A1**

# EUROPEAN PATENT APPLICATION

(21) Application number: **90310412.3**

(22) Date of filing: **24.09.90**

(51) Int. Cl.⁵: **G01R 23/00, G01R 23/16**

(30) Priority: **23.09.89 GB 8921539**

(43) Date of publication of application:
**02.05.91 Bulletin 91/18**

(84) Designated Contracting States:
**GR**

(71) Applicant: **THE VICTORIA UNIVERSITY OF MANCHESTER**
**Oxford Road**
**Manchester. M13 9PL(GB)**

(72) Inventor: **Christodoulou, Marius Sava, c/o Dept.of Eng.**
**University of Manchester, Simon Building,**
**Oxford Road, Manchester M13 9PL(GB)**
Inventor: **Taylor, Antony Roma, c/o Dept.of Eng.**
**University of Manchester, Simon Building,**
**Oxford Road, Manchester M13 9PL,(GB)**
Inventor: **Turner, John Thomas, c/o Dept.of Eng.**
**University of Manchester, Simon Building,**
**Oxford Road, Manchester M13 9PL(GB)**

(74) Representative: **Allman, Peter John et al**
**MARKS & CLERK Suite 301 Sunlight House**
**Quay Street**
**Manchester M3 3JY(GB)**

(54) **Method and apparatus for frequency measurement.**

(57) A method for determining the frequency of an analogue input signal. Spectral components of the signal are obtained from data sampled from the signal by carrying out a transform. The spectral component having the largest spectral valde is identified, and the frequency of the signal is assumed to be the frequency of the spectral component having the largest spectral value. The spectral components are obtained using a set of functions described by a matrix in which each matrix element is a single bit number. The spectral components are accumulated by performing addition and subtraction operations, avoiding the need for relatively complex multiplications. The signal may be converted to a rectangular wave which is applied to each of an array of EXCLUSIVE-OR gates. Each gate also receives inputs corresponding to the matrix elements of a respective function. The gates may be connected to an array of up-down counters which accumulate the spectral values from each of the data samples.

EP 0 425 095 A1

Fig 1

# METHOD AND APPARATUS FOR FREQUENCY MEASUREMENT

The present invention relates to a method and apparatus for determining the frequency of an analogue input signal.

The derivation of velocity and particle size information from the burst type signals produced by Laser Doppler Anemometry (LDA) and Phase Doppler Anemometry (PDA) equipment requires the analysis of high frequency analogue signals generated by a photo-receiver. Traditionally, this signal processing has been accomplished using a frequency counter, transient recorder, or frequency tracker. The former is essentially a time of flight method yielding discrete values of the velocity data and is most suited to sparsely seeded flows. In contrast, the frequency tracker operates best at relatively high particle densities and produces a (more or less) continuous output velocity signal. Both methods impose severe operational constraints with typical limits on the lower Signal to Noise Ratio (SNR) of around 10 for the counter and 5 for the tracker.

In recent years, the increasing demands placed on laser anemometry and, in particular, the development of the phase Doppler technique for particle sizing, have generated a need for higher speeds in digital processing to determine not only the Doppler frequency of each burst but also the phase difference between two or more channels. This has led to the refinement of such techniques as the Fast Fourier Transform (FFT), the use of hard-wired front end stages for purpose-built transient recorder systems, and a continuing search for more efficient signal processing algorithms.

Processing of LDA signals to extract the Doppler frequency component is traditionally accomplished using Zero Crossing detection or spectrum analysis. Of these, the Zero Crossing technique has so far been the most widely used method (in the timer counter and the transient recorder)

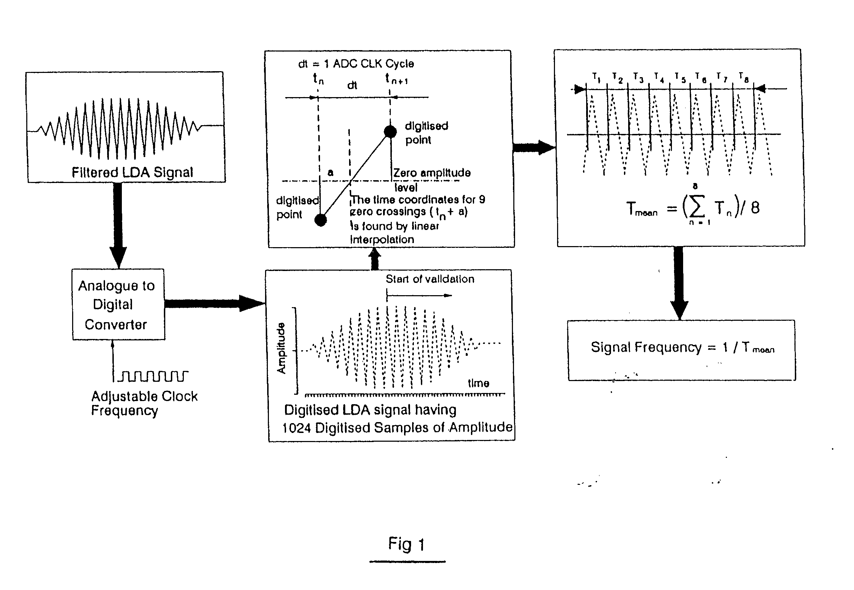

In the Zero Crossing method, the time coordinates of successive signal transitions from negative to positive voltage level (observing the sign of the gradient) are used to determine the periodic time of the signal. Fig. 1 shows a sequence of operations which may be used to obtain the mean periodic time for an individual burst and gives a schematic of the instrumentation system required.

This frequency value may then be accepted or rejected on the basis of validation criteria which are designed to exclude multiple occupancy of the measurement volume, particle crossings at the edge of the measurement volume and signals produced by over-large particles. In one known method, the mean periodic time over eight successive fringes is calculated and compared with the time period for each fringe. All the information from this particular burst signal is then rejected if the variation of any one of the eight fringes exceeds a specified percentage of the mean value.

Other validation schemes (and especially in timer counters) make use of a five-eight comparison in which the periodic time is calculated first as the mean over five periods and then eight periods. If these two values differ by more than a specified percentage, the burst will be rejected.

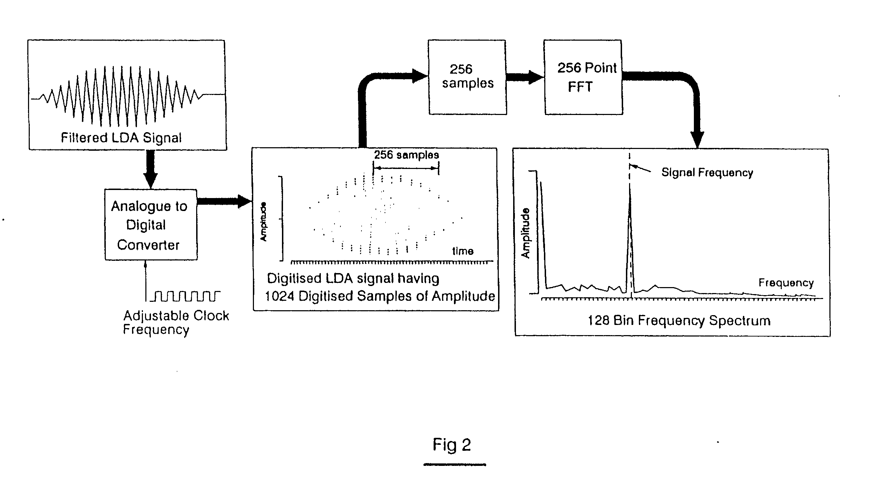

An alternative to the Zero Crossing techniques is to apply spectral analysis to the Doppler burst signals. In this method, the spectral components of the signal are obtained. Subsequently, the components are searched and the component with the largest spectral value is assumed to be the Doppler frequency of the LDA signal. This is illustrated schematically in Fig. 2.

The Fourier transform integral is given by:

$$F(w) = \int_{-\infty}^{+\infty} f(t) e^{-jwt} dt \qquad (1)$$

where t = time, f(t) is the time varying signal, and w is the frequency.

In practice, the transform may be carried out by a digital processor with the continuous LDA signal, f(t), being sampled and represented by a finite number of digital values. The integral is then reduced to a summation with limits determined by the extent of the data set. The digital form of the transform for a sample of N values then becomes

$$F(m) = \sum_{n=0}^{N-1} f(n) e^{-j(2\pi mn/N)} \qquad (2)$$

The spectrum yielded by this equation can only have discrete frequency components $F(m)$ for integer values of $m$ in the range $0 \le m < N/2$.

Hardware is required to produce a system able to compute the spectral components of the signal at the fastest possible speed. Given that every new data value of the sampled signal provides more information about all of the spectral components, it becomes clear that the system must calculate updated values for each spectral element at least as fast as the new data samples arrive.

The equation for the discrete Fourier transform can be re-stated as

$$F(m) = \sum_{n=0}^{N-1} e^{-j(2\pi mn/N)} D(n) \tag{3}$$

where $D(n)$ are the N discrete values representing the function $(f)t$.

For the sake of illustration, take the case of $N = 8$ and consider only the real part of the transform. Then

$$\text{Real } [F(m)] = \sum_{n=0}^{7} \cos(2\pi mn/8)\, D(n). \tag{4}$$

This has the form of the matrix equation set $\underline{F} = M\,\underline{D}$ and can be written as

$$\begin{vmatrix} \text{Real } F(0) \\ \text{Real } F(1) \\ \text{Real } F(2) \\ \text{Real } F(3) \\ \text{Real } F(4) \\ \text{Real } F(5) \\ \text{Real } F(6) \\ \text{Real } F(7) \end{vmatrix} = \begin{vmatrix} 1.0 & 1.0 & 1.0 & 1.0 & 1.0 & 1.0 & 1.0 & 1.0 \\ 1.0 & 0.7 & 0.0 & -0.7 & -1.0 & -0.7 & 0.0 & 0.7 \\ 1.0 & 0.0 & -1.0 & 0.0 & 1.0 & 0.0 & -1.0 & 0.0 \\ 1.0 & -0.7 & 0.0 & 0.7 & -1.0 & 0.7 & 0.0 & -0.7 \\ 1.0 & -1.0 & 1.0 & -1.0 & 1.0 & -1.0 & 1.0 & -1.0 \\ 1.0 & -0.7 & 0.0 & 0.7 & -1.0 & 0.7 & 0.0 & -0.7 \\ 1.0 & 0.0 & -1.0 & 0.0 & 1.0 & 0.0 & -1.0 & 0.0 \\ 1.0 & 0.7 & 0.0 & -0.7 & -1.0 & -0.7 & 0.0 & 0.7 \end{vmatrix} \begin{vmatrix} D(0) \\ D(1) \\ D(2) \\ D(3) \\ D(4) \\ D(5) \\ D(6) \\ D(7) \end{vmatrix} \tag{5}$$

One point to note here is that $F(1) = F(6)$, $F(2) = F(6)$ and $F(3) = F(5)$. Therefore only half the spectral components $F(m)$ need to be computed and, in general, calculation need only be performed in the range $0 \le m \le N/2$.

Next, consider the processing to be performed when the first data sample $D(O)$ has been captured. The five ($= N/2 + 1$) spectral elements are calculated by multiplying $D(O)$ by the corresponding row in column zero of the matrix.

$$\begin{vmatrix} F_0(0) \\ F_0(1) \\ F_0(2) \\ F_0(3) \\ F_0(4) \end{vmatrix} = \begin{vmatrix} 1.0 \\ 1.0 \\ 1.0 \\ 1.0 \\ 1.0 \end{vmatrix} D(0)$$

Subsequently, as the $n^{th}$ data sample $D(n)$ is captured, it is multiplied by the elements in the $n^{th}$ column and the results are added to the previous values in $F_{n-1}(m)$.

4

EP 0 425 095 A1

$$\begin{vmatrix} F_n(0) \\ F_n(1) \\ F_n(2) \\ F_n(3) \\ F_n(4) \end{vmatrix} = \begin{vmatrix} F_{n-1}(0) \\ F_{n-1}(1) \\ F_{n-1}(2) \\ F_{n-1}(3) \\ F_{n-1}(4) \end{vmatrix} + \begin{vmatrix} M_{0n} \\ M_{1n} \\ M_{2n} \\ M_{3n} \\ M_{4n} \end{vmatrix} \quad D(n)$$

This process continues until all 8 data samples have been collected. The hardware required to achieve this would be $N/2 + 1$ accumulators (full adder and register) to store the spectral elements $F(m)$, and $N/2$ multipliers to produce the updated values of the new data sample multiplied by the appropriate matrix column (note that a multiplier is not required for $F(0)$). Thus, a total of $N^2/2$ storage locations would be required to hold the elements of the matrix M. The data paths to the multipliers would be at least 8 bits wide and those around the accumulators would be at least 16 bits wide.

In the general case, computation of both the real and imaginary parts of the transform would be required since sampling of the signal begins with arbitrary phase. This necessitates extra computation and nearly doubles the hardware requirement to obtain the real part of the spectrum. It therefore becomes clear that implementation of the Direct Fourier transform would incur a prohibitively large amount of hardware.

A computational scheme known as the Fast Fourier transform (or FFT) due to Cooley and Tukey (J W Cooley and J W Tukey. Math. Comput. Vol 19, 1965) will lead to a reduction in the required hardware. For a transform with N data points, the $N^2$ operations of the DFT are reduced to $N\log_2 N$ complex additions and subtractions. It is the case however that one complex addition takes two real additions i.e. $(A+jB)(C+jD) = (A+C) +j(C+D)$ and $N/2\log_2 N$ complex multiplications and that one complex multiplication takes four real multiplications i.e. $(A+jB)(C+jD) = (AC-BD)+j(AD+BC)$. Holland and Mather (B Holland and J Mather. Monolithic frequency domain processing with 450 MFLOPS throughput. Electronic Eng. Vol 61 No 752 August 1989) describe the features of a device which uses the radix version 4 of the FFT. Their design, manufactured by Plessey as PDSP 16510, will compute a 256 point transform in 19.2 microseconds.

It is known from for example the publication "Digital filter design handbook" by F.J. Taylor, published by Marcel Dekker Inc., 1983, ISBN 0-8247-1357-5 page 116, to provide a polarity coincident correlator in which uniform noise is used to "dither" two signals which possess a known cross-correlation function. If the two signals are strongly correlated, they will possess similar zero-crossing patterns. Since the output of zero crossing detectors to which the signals are applied represent a binary valued process, calculation can be performed with a simple EXCLUSIVE - OR gate. The value of the gate output can be computed using for example an up-down counter. The correlator can then be used in a spectral analysis capacity, but it requires the addition of uncorrelated (statistically independent) uniformly distributed noise to two signals of interest.

It is an object of the present invention to provide an improved method and apparatus for determining the frequency of an analogue signal.

According to the present invention, there is provided a method for determining the frequency of an analogue input signal, in which spectral components of the signal are obtained from data sampled from the signal by carrying out a transform, the spectral component having the largest spectral value is identified, and the frequency of the signal is assumed to be the frequency of the spectral component having the largest spectral value, wherein the spectral components are obtained using a set of functions described by a matrix in which each matrix element is a single bit number, the spectral compnents being accumulated by performing addition and subtraction operations.

The invention also provides an apparatus for determining the frequency of an analogue input signal, comprising means for sampling the signal, transforming means for carrying out a transform of the sampled signal to obtain spectral components of the signal, means for identifying the spectral component having the largest spectral value, and means for indicating that the frequency of the signal is the frequency of the identified spectral component, wherein the transforming means defines a matrix which describes a set of functions, each element of the matrix is a single bit member, and means are provided for accumulating the spectral components by addition and subtraction.

The accumulating means may be adapted to add to a spectral value a data sample if the corresponding matrix element has a first value and to subtract from the spectral value a data sample if the corresponding matrix element has a second value.

The apparatus may comprise means for converting the signal into a rectangular wave such that each data sample has one of two values, and the said set of functions may be Walsh functions. Alternatively, each function of the said set may represent a waveform of a respective predetermined frequency of substantially uniform mark/space ratio.

Preferably, the accumulating means comprises an array of EXCLUSIVE-OR gates and an array of up-down counters, each gate receiving a common single bit input carrying the data samples and a respective single bit input corresponding to elements of the matrix, related to one function, and each up-down counter receiving the output of a respective gate.

In one arrangement, a series of comparison signals is generated, each comparison signal being in the form of a series of outputs each representing a single element of the matrix and each series of outputs representing a function of predetermined frequency. The polarity of each sample of the rectangular wave is compared with the polarity of each of the comparison signals. A count is established in respect of each comparison signal corresponding to the difference between the number of occasions on which the compared polarities are the same and the number of occasions on which the compared polarities are not the same. The frequency of the signal is identified as that of the function of predetermined frequency corresponding to the count with the largest modulus.

Embodiments of the present invention will now be described, by way of example, with reference to the accompanying drawings, in which:

Fig. 1 schematically illustrates a zero crossing method of frequency determination in accordance with the prior art;

Fig. 2 schematically illustrates a FFT method of frequency determination in accordance with the prior art;

Fig. 3 illustrates an embodiment of the present invention;

Fig. 4 are illustrative examples of simulated LDA signals for different noise levels,

Fig. 5 illustrates errors in the prediction of frequency as a function of frequency and signal to noise ratio,

Figs. 6, 7 and 8 illustrate results achieved in a first implementation of the present invention;

Figs. 9, 10 and 11 illustrate results achieved in a second implementation of the present invention,

Figs. 12 and 13 illustrate results achieved in a third implementation of the present invention;

Fig. 14 illustrates results achieved with a real LDA signal using the techniques of the prior art, and

Fig. 16 illustrates results achieved with a real LDA signal using the first, second and third implementations of the present invention.

For the reasons stated above, the application of known Fourier transform techniques requires complex hardware. In particular, the sine and cosine values in the Fourier transform matrix demand a multiplication stage in the process. This multiplication stage can be avoided if in accordance with the invention a matrix is used in which all the elements can take on only one or other of two values. Such elements can be represented by a single bit number, enabling multiplication stages to be replaced by simple additions and subtractions. This in turn significantly reduces the hardware required to determine the dominant frequency component in for example an LDA signal whilst maintaining high processing rates.

If each matrix element can take only two values, it is possible to eliminate all N multiples referred to above and to reduce the matrix storage requirements to $N_2$ bits. Furthermore, the data paths around the accumulators are smaller than in the Fourier transform implementation.

A set of orthogonal functions defined throughout a time interval of interest and of binary value is due to Walsh. Following the notation of Harmuth (H F Harmuth. Transmission of information by orthogonal functions. Springer-Verlag. 1972), these Walsh functions are denoted by $WAL(i,\theta)$ and can be divided into a set of even functions denoted by $CAL(i,\theta)$ and odd functions denoted by $SAL(i,\theta)$. The functions take values of $\pm 1$ and are defined over the interval $-1/2 \leq \theta < 1/2$ which may be considered to represent some normalised time domain. The argument i is similar to the frequency w used previously and is one-half the average number of zero crossings in the interval $\theta$ (in Harmuth's notation, this is known as the "sequency").

It can be shown that the following relationships apply:

$SAL(i,\theta) = WAL(2i-1,\theta)$

$CAL(i,\theta) = WAL(2i,\theta)$

Higher order (higher sequency) Walsh functions can be derived from lower order ones using the regression formula:

$$WAL(2j+p,\theta) = (-1)^{(j/2)+p} (WAL(j,2(\theta+1/4)) + (-1)^{j+p} WAL(j,2(\theta-1/4)))$$

where p = 0 for generating CAL functions and pi for generating SAL functions.

The exponent j/2 is calculated in integer arithmetic. For example, if j = 1 then j/2 = 0 or if j = 3 then j/2 = 1 etc.

The function WAL (j,2θ) has the same shape as WAL (j,θ) but is compressed into the shorter range $-1/4 \leq \theta < 1/4$.

Changing the argument θ to θ + 1/4 represents a shift to the left by 1/4 of the θ (time) axis.

An even more significant characteristic is that the Walsh functions can be generated by multiplying functions together. Since the functions only take values of ±1, this is easily achieved in hardware using an EXCLUSIVE OR gate. The working relationship is

$WAL(i,\theta) = WAL(j,\theta) \times WAL(k,\theta)$

where i = j + k, j and k are represented in binary form, and the addition is carried out bitwise to modulo 2 (eg 5 modulo 2 = integer remainder of 5 divided by 2 = 1 ).

e.g.

$$j = 5 \qquad 0101$$
$$k = 3 \qquad 0011$$
$$i = 6 \qquad 0110$$

This multiplicative property enables the Walsh functions to be generated in real time and trades-off the logic needed to generate the required set of functions against the elimination of memory to store the matrix coefficients. As the number of functions increases, the propagation delays in the logic will increase and may become comparable to the access times of high speed memory.

The discrete Walsh transform may be employed to generate the even part of the "spectrum". For the sake of simplification, consider a data set consisting of only 8 points. The m spectral components are then evaluated using the equation

$$E(m) = \sum_{n=0}^{7} CAL(m, (n-4)/8) \; D(n) \qquad \text{for } 0 \leq m < 8.$$

Writing this in the familiar matrix form adopted above yields

$$
\begin{vmatrix} E(0) \\ E(1) \\ E(2) \\ E(3) \\ E(4) \\ E(5) \\ E(6) \\ E(7) \end{vmatrix}
=
\begin{vmatrix}
1 & 1 & 1 & 1 & 1 & 1 & 1 & 1 \\
-1 & -1 & 1 & 1 & 1 & 1 & -1 & -1 \\
1 & -1 & -1 & 1 & 1 & -1 & -1 & 1 \\
-1 & 1 & -1 & 1 & 1 & -1 & 1 & -1 \\
1 & -1 & 1 & -1 & 1 & -1 & 1 & -1 \\
-1 & 1 & 1 & -1 & 1 & -1 & -1 & 1 \\
1 & 1 & -1 & -1 & 1 & 1 & -1 & -1 \\
-1 & -1 & -1 & -1 & 1 & 1 & 1 & 1
\end{vmatrix}
\begin{vmatrix} D(0) \\ D(1) \\ D(2) \\ D(3) \\ D(4) \\ D(5) \\ D(6) \\ D(7) \end{vmatrix}
$$

Note that for m > N/2, the odd functions are produced according to the equation

CAL(m,(n-4)/8) - SAL(N-m,(n-4)/8) for N > m > N/2.

Thus, the real time computation can proceed as described above for the Discrete Fourier transform except that no multiplications are required. The first data sample, D(0), is either added to or subtracted from the spectral elements E(m) according to the element m in the column zero of the matrix

$$
\begin{vmatrix} E_0(0) \\ E_0(1) \\ E_0(2) \\ E_0(3) \\ E_0(4) \\ E_0(5) \\ E_0(6) \\ E_0(7) \end{vmatrix}
=
\begin{vmatrix} 1 \\ -1 \\ 1 \\ -1 \\ 1 \\ -1 \\ 1 \\ -1 \end{vmatrix}
D(0)
$$

Similarly, for the $n^{th}$ data sample, D(n), the $n^{th}$ column of the matrix determines whether it is added to or subtracted from E(m).

$$\begin{vmatrix} E_n(0) \\ E_n(1) \\ E_n(2) \\ E_n(3) \\ E_n(4) \\ E_n(5) \\ E_n(6) \\ E_n(7) \end{vmatrix} = \begin{vmatrix} E_{n-1}(0) \\ E_{n-1}(1) \\ E_{n-1}(2) \\ E_{n-1}(3) \\ E_{n-1}(4) \\ E_{n-1}(5) \\ E_{n-1}(6) \\ E_{n-1}(7) \end{vmatrix} + \begin{vmatrix} M_{0n} \\ M_{1n} \\ M_{2n} \\ M_{3n} \\ M_{4n} \\ M_{5n} \\ M_{6n} \\ M_{7n} \end{vmatrix} \quad D(n)$$

These calculations are repeated until all eight data samples have been processed. It should be observed that these equations enable both odd and even components of the "spectrum" to be computed.

A further reduction in hardware is possible if $D(n)$ is represented as a single bit value. This can be achieved by replacing the discrete values $D(n)$ with the sign of the high pass filtered LDA signal, to yield the values $sgn(D(n))$. This technique is referred to herein as "Clipping" and can be implemented using a simple comparator with a single threshold.

At first sight, this method of processing seems likely to apply a drastic distortion to an LDA signal. However, noting that the basic signal consists of nothing more than a single sinusoid with Gaussian amplitude modulation, and that this frequency will be preserved in the sign information, then this distortion is irrelevant. If it were not, the zero crossing techniques would not work, either. It is also interesting to note (see Harmuth) that the single bit representation of the signal is a closer match to the Walsh functions than is the sinusoidal LDA signal.

Taking the previous parameters for illustrative purposes, the even Walsh components are calculated using

$$E(m) = \sum_{n=0}^{7} CAL(m,(n-4)/8) \; sgn(D(0))$$

Similarly, on arrival of the nto data sample, $D(n)$, the components $E_n(m)$ are calculated using

$$\begin{vmatrix} E_n(0) \\ E_n(1) \\ E_n(2) \\ E_n(3) \\ E_n(4) \\ E_n(5) \\ E_n(6) \\ E_n(7) \end{vmatrix} = \begin{vmatrix} E_{n-1}(0) \\ E_{n-1}(1) \\ E_{n-1}(2) \\ E_{n-1}(3) \\ E_{n-1}(4) \\ E_{n-1}(5) \\ E_{n-1}(6) \\ E_{n-1}(7) \end{vmatrix} + \begin{vmatrix} M_{0n} \\ M_{1n} \\ M_{2n} \\ M_{3n} \\ M_{4n} \\ M_{5n} \\ M_{6n} \\ M_{7n} \end{vmatrix} \quad sgn(D(n))$$

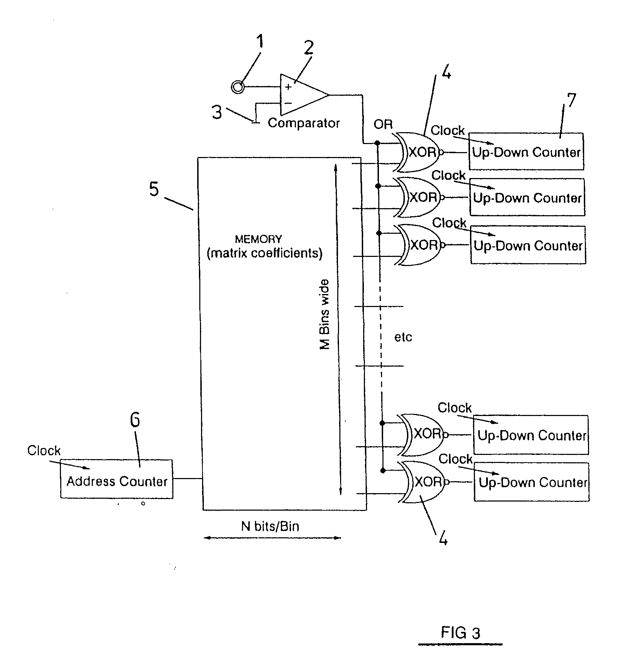

Since the product of $sgn(D(n))$ and $M_{mn}$ is either $+1$ or $-1$, the new value of element $E_n(m)$ may be obtained by either incrementing or decrementing the previous value by one. Consequently, the accumulator circuitry can be replaced with an up/down counter which further reduces the amount of logic required and the widths of the data paths. This is illustrated in Fig. 3.

Referring to Fig. 3, the analogue data LDA signal is applied to positive input 1 of a comparator 2. The comparator has its negative input connected to a reference voltage source 3. As a result the output of the comparator is a rectangular wave the frequency of which corresponds to the frequency, of the LDA signal. The output of the comparator is applied to each of a series of EXCLUSIVE-OR (x-OR) gates 4.

A memory 5 stores the matrix coefficients of the Walsh function as described above. The memory is M bins wide with N bits per bin. N represents the resolution of the frequency spectrum. An address counter 6 reads out the matrix coefficients as a sequence of N steps with one element of the matrix being read at each step. Each element is applied to a respective gate 4. The address counter reads out the matrix element at a rate determined by a clock signal. That clock signal is also applied to each of an array of up-down counters 7.

The output of the comparator 2 alternates between two polarities that may be represented as $-1$ and $+1$. Equally, each input to the gate 4 from the memory 5 may be represented as either $-1$ or $+1$. The response of an EXCLUSIVE-OR gate to logical inputs of "o" and "I" may be summarised as:
$0 \times 0 = 1$

$0 \times 1 = 0$
$1 \times 0 = 0$
$1 \times 1 = 1$

If we assign logical values of "0" to -1 above and "1" to +1 above, then each counter will increment each time the respective gate receives inputs corresponding to -1,-1 or +1,+1, and decrement each time the respective gate receives inputs corresponding to -1,+1 or +1,-1. Thus the modulus of the number stored in each counter is a measure of the magnitude of the spectral component associated with the respective function represented by elements stored in the memory.

The dominant frequency can thus be identified by reference to the function associated with the counter storing the number of largest modulus.

The polarity detected LDA signal output by the comparator 2 of Fig.3 exhibits a regular periodic structure and typically appears as a square wave having equal mark-space ratio. In contrast, the Walsh functions exhibit an irregular mark-space ratio across the range: this implies that many Walsh functions may be needed to represent a given clipped LDA signal. In consequence, the energy of the Doppler signal spreads over a number of Walsh functions, dominated by the principal component for which the sequency equals the Doppler frequency. This difficulty can reduce the effectiveness of the Walsh transform as a frequency detection method.

As an alternative to the use of Walsh functions, a set of functions taking values of ±1 and which have nearly equal mark-space ratios may be used. These functions are specified by the positions of the zero crossing points which occur at integer multiples of $N/(m+1)$ in the range 0 to N where $0 \leq m < N$. This approach is referred to hereinafter as the "polarity coincidence" method.

Following the same arguments as before, and assuming a restricted data sample for which N = 8, then the elements of the matrix M would be

$$
\begin{array}{rrrrrrrr}
1 & 1 & 1 & 1 & 1 & 1 & 1 & 1 \\
1 & 1 & 1 & 1 & -1 & -1 & -1 & -1 \\
1 & 1 & 1 & -1 & -1 & -1 & 1 & 1 \\
1 & 1 & -1 & -1 & 1 & 1 & -1 & -1 \\
1 & 1 & -1 & -1 & 1 & -1 & -1 & 1 \\
1 & 1 & -1 & 1 & -1 & -1 & 1 & -1 \\
1 & 1 & -1 & 1 & -1 & 1 & -1 & 1 \\
1 & -1 & 1 & -1 & 1 & -1 & 1 & -1 \\
\end{array}
$$

The justification for this choice of functions is that they offer a good match to the type of signal of interest here. Care is needed, however, since the functions do not form a complete orthogonal set, making them unsuitable for general transform applications. Fortunately, these restrictions can be ignored when the principal concern is to determine the frequency of a single and dominant sinusoidal component.

The method of calculating the Doppler frequency and the arrangement of the hardware remains exactly the same as for the application of the "Clipped" Walsh transform (Fig. 3). Depending on the signal processing requirements, either method can be selected by choosing the appropriate values for the coefficients in the matrix.

Two types of test were carried out to assess the performance of the alternative signal analysis techniques. The first involved the use of digitally generated "bursts" of known frequency and known levels of signal to noise ratio (SNR). The aim here was to establish the accuracy with which the Doppler frequency could be predicted for a range of SNR levels. Each signal was symmetrical about the time axis and was generated using a sine wave with a Gaussian amplitude envelope and a fixed number of zero crossings corresponding to 128 fringes. Noise was added to the burst-type signal using a random number generator characterised by a Normal Distribution in amplitude about zero and a pre-specified rms level to give the desired Signal to Noise Ratio based upon the definition

SNR = peak signal amplitude / RMS noise

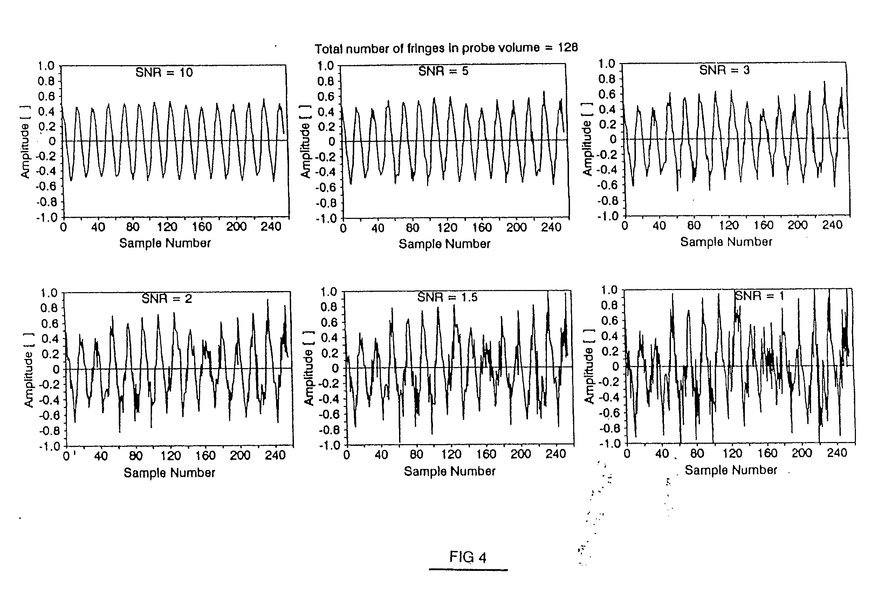

NB This figure actually represents an over-estimate of the SNR for other positions within the burst due to the Gaussian variation of the signal amplitude. Typical samples of these signals are shown in Fig. 4.

The Zero Crossing and FFT techniques were first used to predict the known frequency of the artificial signals.

Working with a sample of N digital values of the incoming signal, a maximum of N/2 spectral components may be determined. The signal is sampled at a rate $f_s$ which corresponds to a cut-off frequency for the spectrum of $f_c = f_s/2$. Each spectral component is determined to an accuracy of $\pm f_c/N$. The objective is to determine the frequency of the spectral element containing the largest value. For this, a 256 point FFT corresponding to N = 128 bins was adopted throughout: this yields approximately one-percent error of the full scale frequency (i.e. particle velocity).

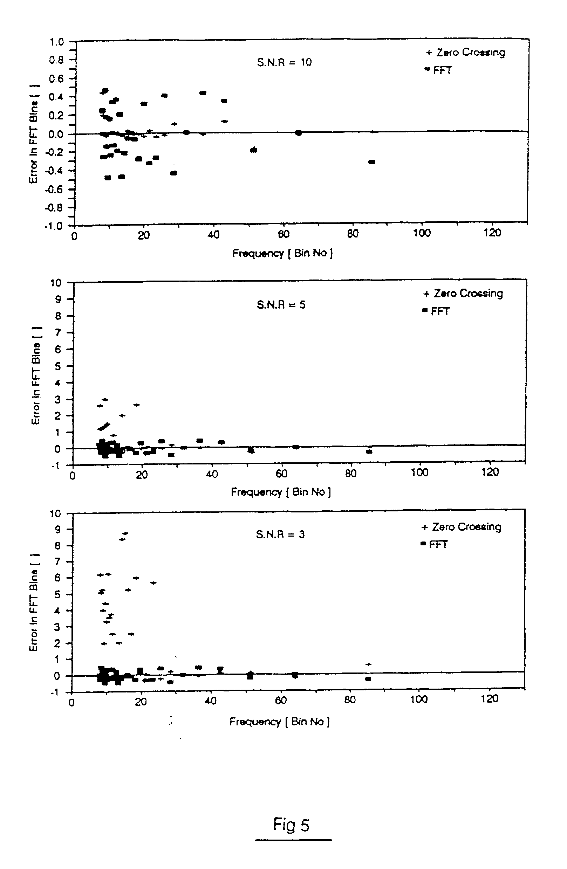

Using the simulated signals in turn and calculating the Doppler frequency for each set of conditions produced the results presented in Fig. 5. The difference (or "error") between the known input frequency and the derived frequency is expressed here as the number of FFT bins.

The data in Fig. 5, corresponding to high quality signals with a SNR of 10, indicate that the Zero Crossing technique performs exceptionally well over the whole frequency range to yield error levels very close to zero. The FFT method is comparatively less accurate but still produces errors no greater than ±0.5 FFT bins. Obviously, the Zero Crossing technique is capable of greater accuracy in this situation because the time coordinates of the zero crossings (i.e. the period of the signal) may be established using an interpolation technique. In the present case, a linear approximation was used.

For signals with a SNR of 5, the results again show good performance for the Zero Crossing method at the high frequency end of the spectrum although the resolution falls rapidly below bin number 20. This SNR level is commonly regarded as the lower limit for the Zero Crossing and Frequency Counting techniques. In comparison, the FFT shows better performance over the whole frequency range with errors remaining inside the theoretical bound of ±0.5 FFT bins. For a lower SNR of 3 (Fig. 5), the Zero Crossing prediction is again adequate down to bin number 20 although the resolution worsens rapidly below this frequency.

The Zero Crossing method appears to perform best at the higher end of the frequency spectrum. On first sight, this may be surprising since here there will be fewer data points in one period than for the lower frequency signals. However, an explanation soon emerges when the mode of operation of the method and the influence of noise are considered. Assuming that the sampling rate remains fixed, the frequency of the signal is determined by measuring the time between successive transitions (or sign changes) in the same direction past a given threshold value. For low frequency signals, there will be a relatively large number of data points per period and several of these will have values close to the threshold value. The influence of the noise may then be sufficient to cause spurious crossings of the threshold, leading to a false indication of the Doppler frequency. In the case of higher frequency signals, however, fewer successive data values will lie close to the threshold so that the method will become more accurate.

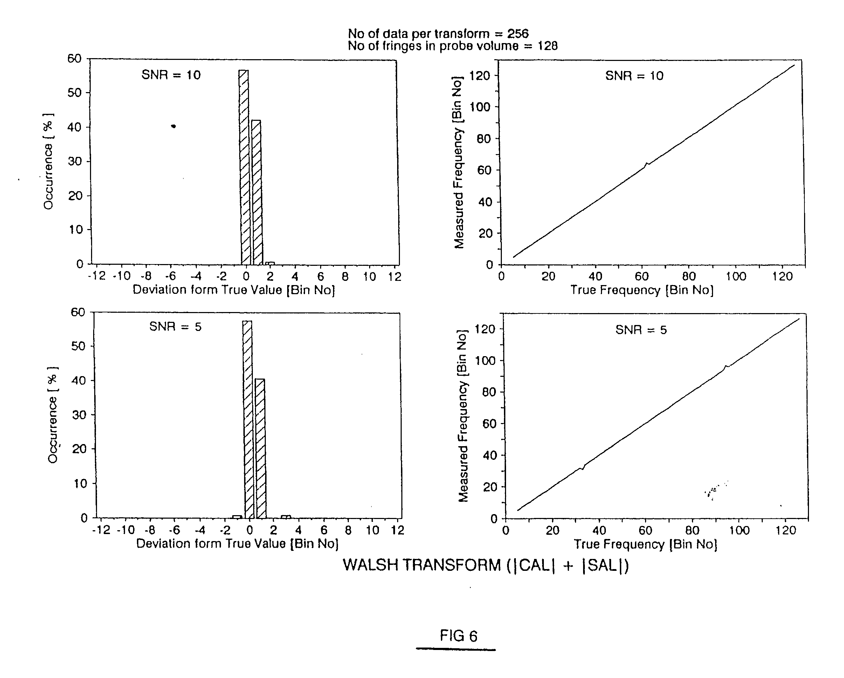

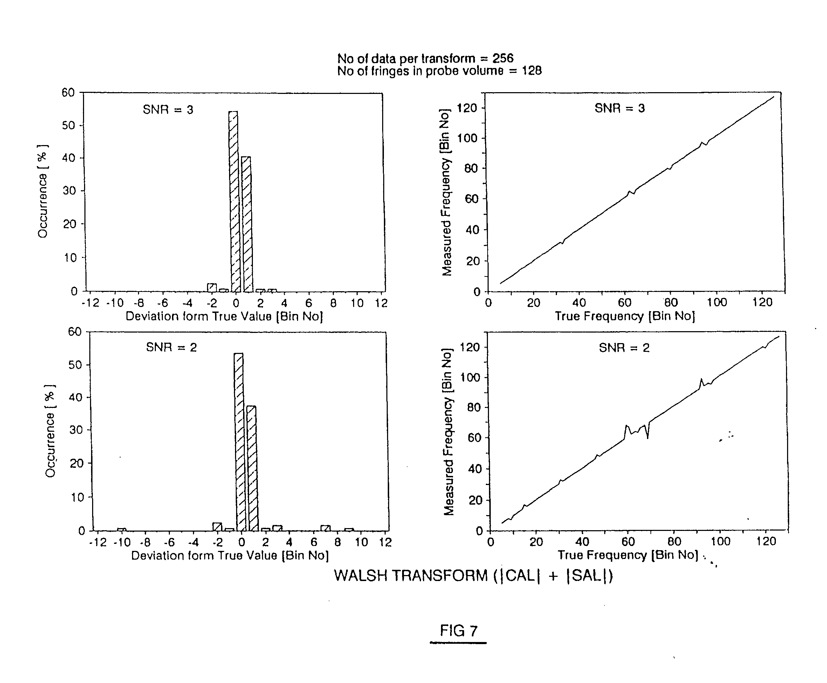

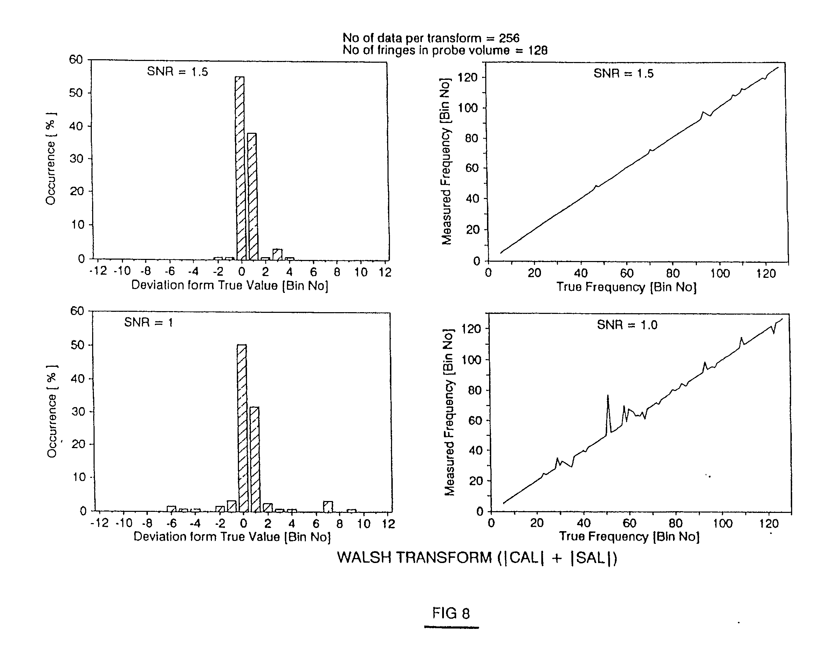

Using the simulation methods described earlier, the Walsh Function method has been used to determine the Doppler frequency of the computer simulated Doppler bursts. Figs. 6 to 8 show the results of these tests with simulated data. The left hand graphs show the deviation of the detected frequencies from the known input frequency: ideally, zero deviation would occur. Inspection of the data shows that there is excellent agreement over the whole frequency range with a tendency to read high. In terms of its capability to withstand noise, the scheme works well down to an SNR of 3. Thereafter, the accuracy of detection deteriorates and is particularly poor in the centre of the frequency range.

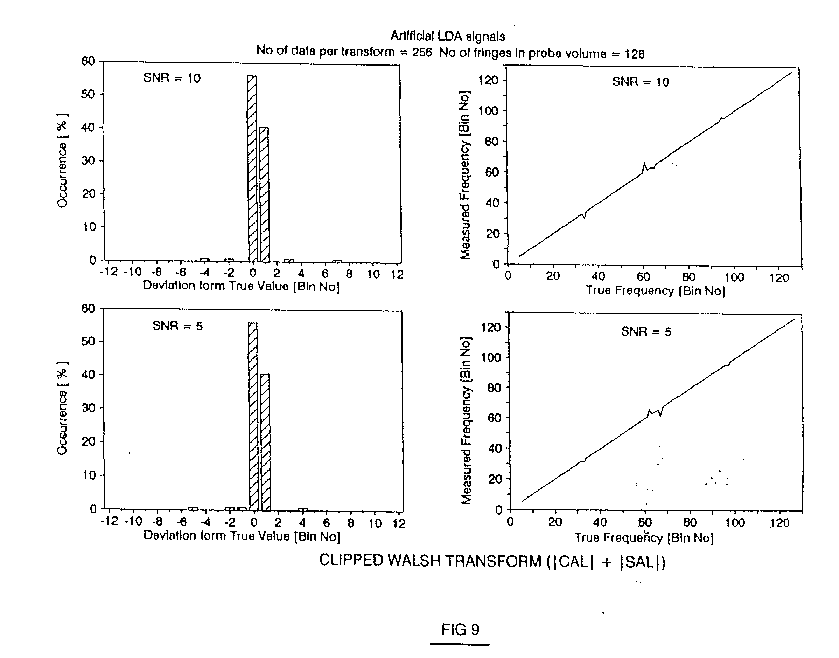

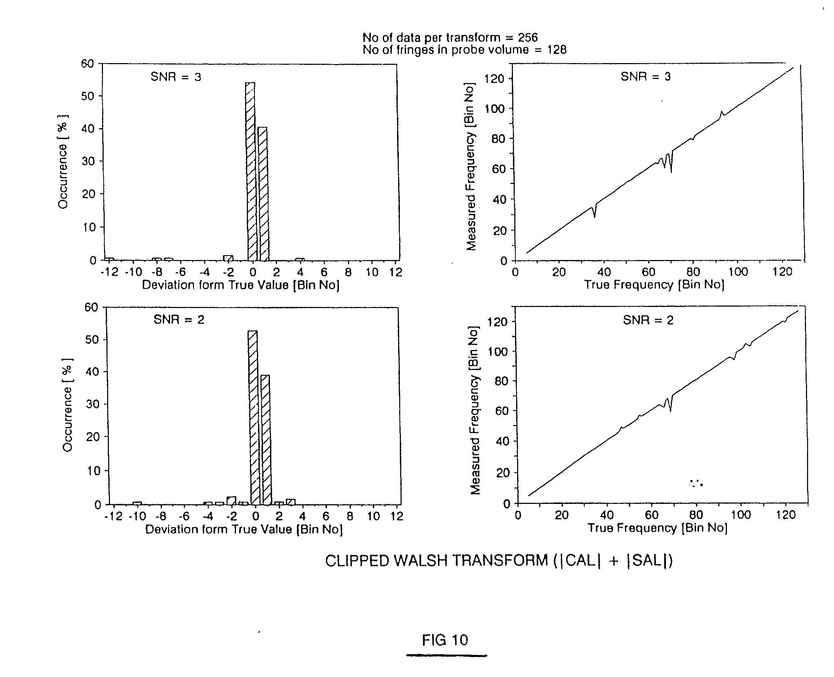

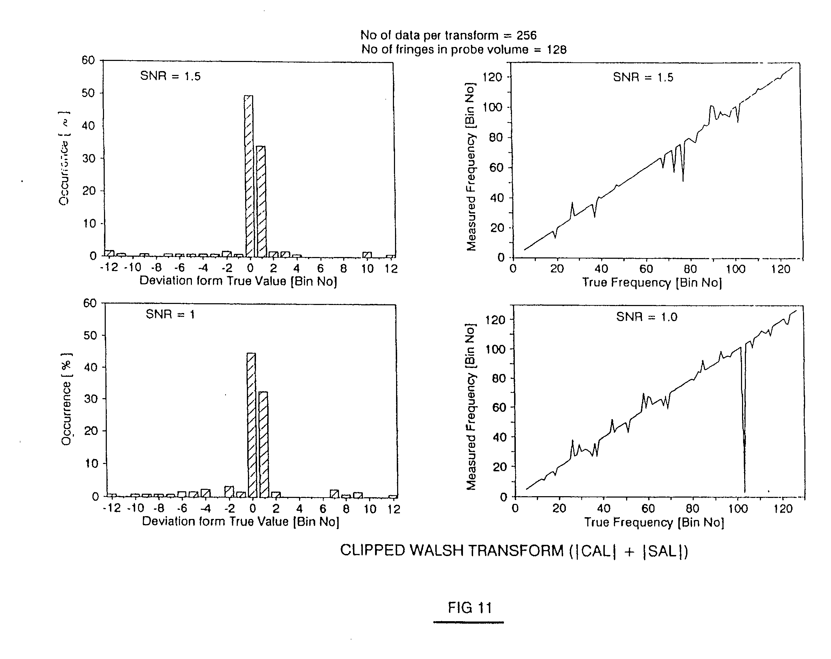

The result of processing the same simulated data using the clipped Walsh transform techniques are shown in Figs. 9 to 11. Again, a degradation in performance is observed as the SNR decreases but the scheme is usable down to a SNR of about 3.

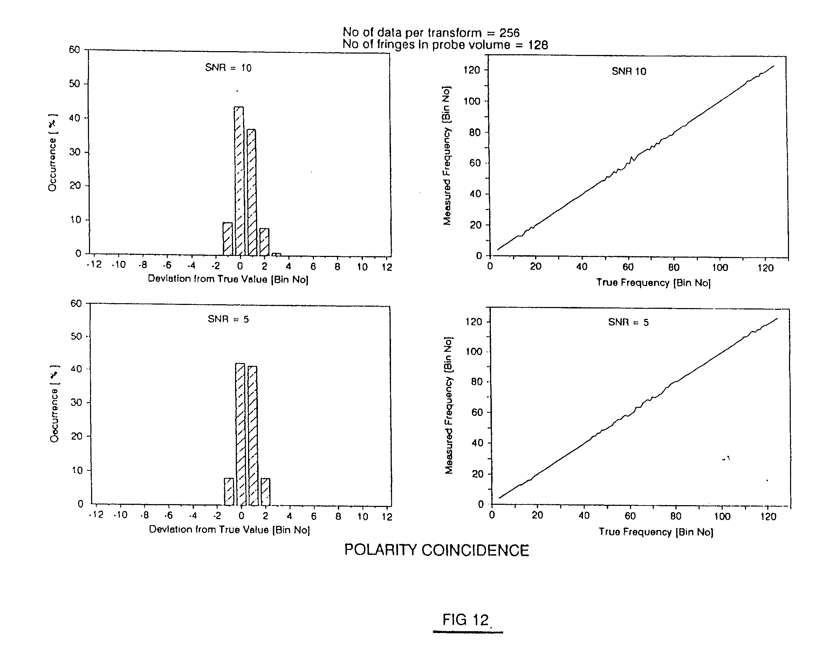

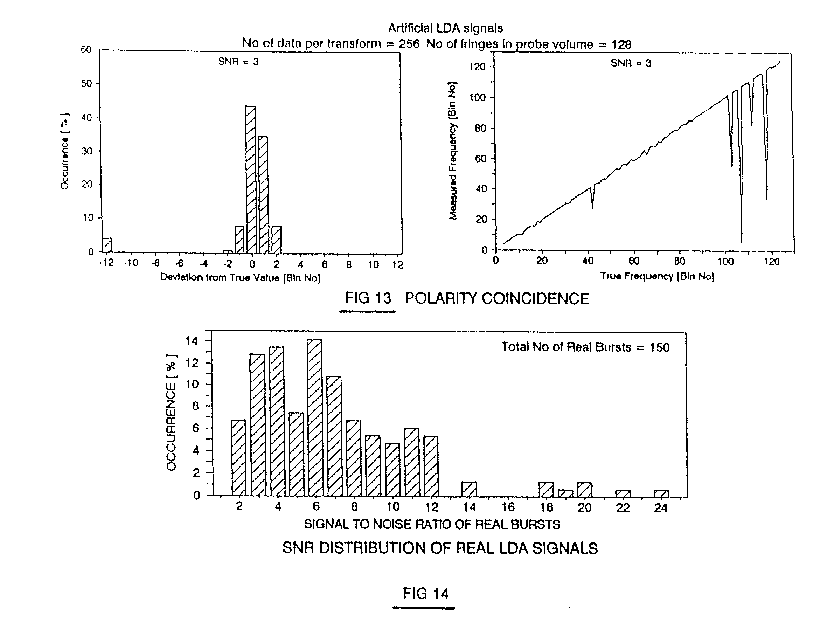

Figs. 12 and 13 show the performance of the polarity coincidence processing method. It can be seen that the technique works well for SNR values in excess of 5.

The second evaluation performed on the alternative processing techniques involved the use of real LDA bursts covering a wide range of frequency levels. These signals, taken from a single channel system operated in forward scatter, were band-pass filtered, digitised using a transient recorder, and then stored. About 140 such signals covering a wide range of operational conditions with SNR between 2 and 12 (Fig. 14) were recorded and used in the study. In each case, the time series data consisted of 1024 values and obtained with several different sampling rates.

When dealing with real LDA bursts, the true frequency is unknown and consequently the accuracy of signal processing techniques can only be assessed in relative terms. The FFT results are used as the reference values and the frequency estimates from the other methods are compared against them.

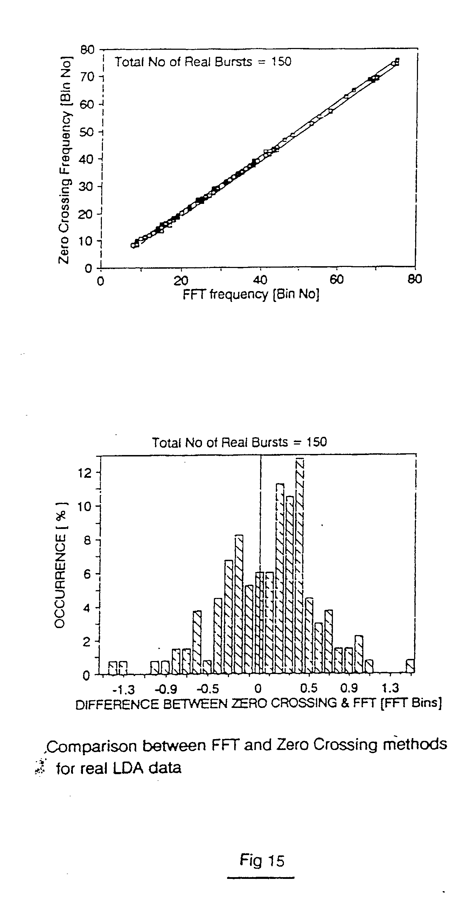

Fig. 15 shows the estimated frequency using the zero-crossing technique, against that found by the FFT method. The data are shown to be within ± 1 FFT bins as confirmed by the distribution of the difference between the FFT and the zero crossing estimates. These results are in good agreement with those shown using artificial LDA bursts.

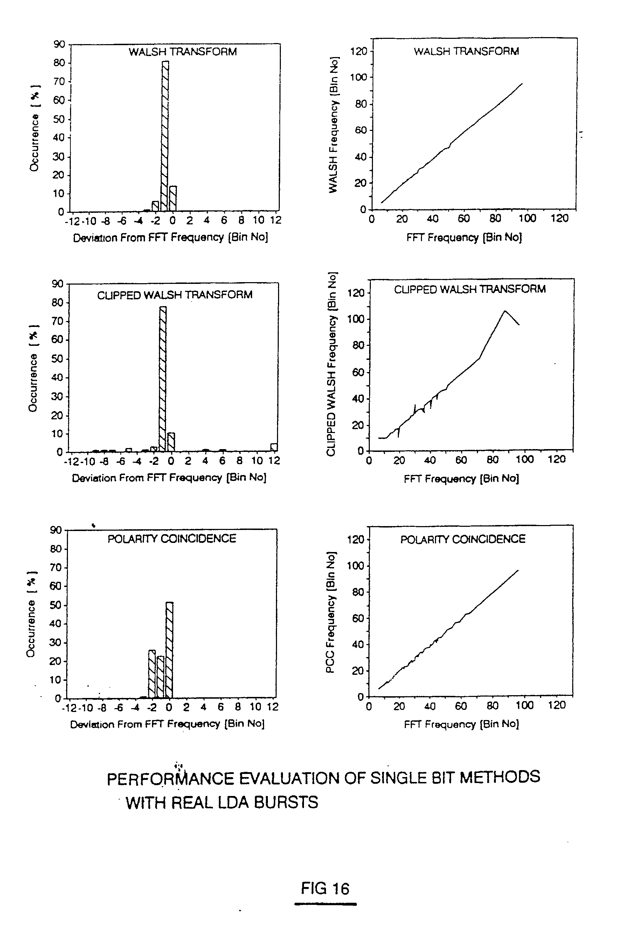

Fig. 16 shows the performance of processing techniques in accordance with the invention when applied to real LDA data. In each case, 256 points of the time series were processed after the signal passed a certain threshold level. It would appear from this preliminary investigation that the Polarity Coincidence technique shows less scatter than the Clipped Walsh transform method which is in correspondence with the simulation results.

Reference is made above to the use of transient recorders. This type of instrument captures each individual burst signal using a high speed analogue to digital convertor and transmits this information to a computer. Processing of the signal to obtain flow velocity is then achieved by software. This type of system has the important advantages of low cost and the capability to operate under most signal conditions dependent upon the sophistication of the post processing. Although such techniques are frequently used in LDA signal processing, a principal limitation hitherto has been that general purpose transient recording instruments cannot match the data processing rates achieved by commercial LDA signal processors.

Despite this limitation, total burst capture using a transient recorder technique has significant advantages over virtually every other form of system. Not least of these is in the ability afforded to the operator to choose different levels of software sophistication dependent upon requirements and signal quality.

A two channel transient recording system has been developed which is capable of synchronous sampling at up to $10^8$ sample/s on each channel. Data is digitised to eight bits of resolution and up to 4 thousand samples including a maximum of 4 thousand pre-trigger values may be captured. Data is transferred to a PDP11/73 processor by DMA at a rate of 500 kbytes/s for subsequent analysis. These rates are limited primarily by the fact that it takes 8 ms to transfer one channel of data (i.e. 4096 data points) from the data acquisition memory to the processor memory.

Experience has shown that the system is extremely versatile and, when coupled with a sophisticated software package, permits a number of different processing techniques to be employed.

The embodiment of the invention described with reference to Fig. 3 has been built using ALTERA EPS5128 devices. These are erasable programmable logic devices consisting of 128 macrocells (providing flip-flops and appropriate gating) and capable of clocking at up to 50MHz. Such a device has been programmed to implement sufficient logic to calculate 16 spectral components with two being required to provide both even and odd components. A total of 16 identical devices is required to calculate the full spectrum consisting of 128 elements. A different device is used to control the system and to provide a hardware determination of the position of the largest spectral element.

A system has been constructed which clocks at a maximum rate of 33MHz and appears to be limited by the access time of the RAM holding the matrix coefficients. The system is capable of a burst analysis rate of 86,000 bursts per second using technology which is currently available.

Thus, the invention has been implemented using simple circuitry which is easily expandable to an arbitrary number of channels. Moreover, a high degree of integration is possible rendering the scheme suitable for implementation in uncommitted logic arrays (ULA). It is estimated that a complete 128 channel system could be implemented in a single application specific integrated circuit (ASIC). With the advent of gallium arsenide gate arrays having internal clocking speeds of the order of 15 GHz, analysis of signals with frequencies of 1 GHz should be possible at burst data rates up to 4 million/s.

In the embodiment described with respect to Fig. 3 EXCLUSIVE-OR gates are used to provide appropriate inputs to the up-down counters. Alternative logic circuits are of course possible. For example, two matrices may be provided, one made up from identical elements to that described in Fig. 3, the other made up from elements such that one matrix is the logical complement of the other, that is if in one matrix an element has value + 1, the corresponding element in the other matrix has value -1. Matrix elements are selected from one matrix if the clipped data signal has one polarity, and from the other matrix if the clipped data signal has the opposite polarity.

## Claims

1. A method for determining the frequency of an analogue input signal, in which spectral components of the signal are obtained from data sampled from the signal by carrying out a transform, the spectral component having the largest spectral value is identified, and the frequency of the signal is assumed to be the frequency of the spectral component having the largest spectral value, wherein the spectral components are obtained using a set of functions described by a matrix in which each matrix element is a single bit number, the spectral components being accumulated by performing addition and subtraction operations.

2. An apparatus for determining the frequency of an analogue input signal, comprising means for sampling the signal, transforming means for carrying out a transform of the sampled signal to obtain spectral components of the signal, means for identifying the spectral component having the largest spectral value, and means for indicating that the frequency of the signal is the frequency of the identified spectral component, wherein the transforming means defines a matrix which describes a set of functions, each element of the matrix is a single bit member, and means are provided for accumulating the spectral components by addition and subtraction.

3. An apparatus according to claim 2, wherein the accumulating means is adapted to add to a spectral value a data sample if the corresponding matrix element has a first value and to subtract from the spectral value a data sample if the corresponding matrix element has a second value.

4. An apparatus according to claims 2 and 3, comprising means for converting the signal into a rectangular wave such that each data sample has one of two values.

5. An apparatus according to claim 2, 3 or 4, wherein the said set of functions are Walsh functions.

6. An apparatus according to claim 4, wherein each function of the said set represent a waveform of a respective predetermined frequency of substantially uniform mark/space ratio.

7. An apparatus according to claim 4, wherein the accumulating means comprises an array of EXCLUSIVE-OR gates and an array of updown counters, each gate receiving a common single bit input carrying the data samples and a respective single bit input corresponding to elements of the matrix, related to one function, and each up-down counter receiving the output of a respective gate.

8. An apparatus according to claim 4, therein two matrices are defined one of which is the logical complement of the other, and the accumulating means comprises an array of up-down counters, each counter receiving a signal derived from one matrix if the data sample has one polarity, and a signal derived from the other matrix if the data sample has the opposite polarity.

9. An apparatus according to claim 4, comprising means for generating a series of comparison signals, each comparison signal being in the form of a series of outputs each representing a single element of the matrix and each series of outputs representing a function of predetermined frequency, means for comparing the polarity of each sample of the rectangular wave with the polarity of each of the comparison signals, means in respect of each comparison signal for establishing a count of the difference between the number of occasions on which the compared polarities are the same and the number of occasions on which the compared polarities are not the same, and means for identifying the frequency of the signal as that of the function of predetermined frequency corresponding to the count with the largest modulus.

**Filtered LDA Signal**

**Analogue to Digital Converter**

Adjustable Clock Frequency

dt = 1 ADC CLK Cycle

$t_n$   dt   $t_{n+1}$

digitised point

Zero amplitude level

digitised point

The time coordinates for 9 zero crossings ($t_n$ + a) is found by linear interpolation

Start of validation

Amplitude

time

**Digitised LDA signal having 1024 Digitised Samples of Amplitude**

$T_1$ $T_2$ $T_3$ $T_4$ $T_5$ $T_6$ $T_7$ $T_8$

$$T_{mean} = \left(\sum_{n=1}^{8} T_n\right)/ 8$$

**Signal Frequency = 1 / $T_{mean}$**

Fig 1

Filtered LDA Signal

Analogue to Digital Converter

Adjustable Clock Frequency

256 samples

Digitised LDA signal having 1024 Digitised Samples of Amplitude

Amplitude

time

256 samples

256 Point FFT

Signal Frequency

Amplitude

Frequency

128 Bin Frequency Spectrum

Fig 2

EP 0 425 095 A1

FIG 3

Total number of fringes in probe volume = 128

FIG 4

EP 0 425 095 A1

Fig 5

FIG 6

WALSH TRANSFORM (|CAL| + |SAL|)

FIG 7

WALSH TRANSFORM (|CAL| + |SAL|)

FIG 8

WALSH TRANSFORM (|CAL| + |SAL|)

Artificial LDA signals
No of data per transform = 256  No of fringes in probe volume = 128

CLIPPED WALSH TRANSFORM (|CAL| + |SAL|)

FIG 9

EP 0 425 095 A1

No of data per transform = 256
No of fringes in probe volume = 128

CLIPPED WALSH TRANSFORM (|CAL| + |SAL|)

FIG 10

EP 0 425 095 A1

No of data per transform = 256
No of fringes in probe volume = 128

CLIPPED WALSH TRANSFORM (|CAL| + |SAL|)

FIG 11

EP 0 425 095 A1

No of data per transform = 256
No of fringes in probe volume = 128

POLARITY COINCIDENCE

FIG 12

Artificial LDA signals

No of data per transform = 256  No of fringes in probe volume = 128

Occurrence [ % ]

Deviation from True Value [Bin No]

SNR = 3

## FIG 13   POLARITY COINCIDENCE

Measured Frequency [Bin No]

True Frequency [Bin No]

SNR = 3

OCCURRENCE [ % ]

SIGNAL TO NOISE RATIO OF REAL BURSTS

Total No of Real Bursts = 150

## SNR DISTRIBUTION OF REAL LDA SIGNALS

## FIG 14

Comparison between FFT and Zero Crossing methods for real LDA data

Fig 15

EP 0 425 095 A1

PERFORMANCE EVALUATION OF SINGLE BIT METHODS
WITH REAL LDA BURSTS

FIG 16

27

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | SIGNAL PROCESSING IV: THEORIES AND APPLICATIONS, PROCEEDINGS OF THE EUSIPCO-88, FOURTH EUROPEAN SIGNAL PROCESSING CONFERENCE, Grenoble, 5th - 8th September 1988, vol. 1, pages 443-446; Q.-G. LIU et al.: "A new separable eigenstructure algorithm for parameter estimation of 2D sinusoids in white noise" * Page 443 * | 1,2,5,7 | G 01 R 23/00 G 01 R 23/16 |
| Y | IEE PROCEEDINGS SECTION A à I, vol. 133, no. 2, Part E, March 1986, pages 73-78, Stevenage, Herts, GB; E. ERIS et al.: "Spectral testing of circuit realisations based on linearisations" * Completely * | 1,2,5,7 | |
| A | PROCEEDINGS OF THE NATIONAL COMMUNICATIONS FORM, vol. XXXXI, no. 2, 1987, pages 1303-1306, Chicago, Illinois, US; G.L. BLANK: "Numerical techniques for spectral estimation" | | |
| A | ISCAS '88, 1988 IEEE INTERNATIONAL SYMPOSIUM ON CURCUITS SYSTEMS, vol. 3, pages 2695-2698, IEEE, New York, US; D. KIM et al.: "Pipeline implementation of Pisarenko's method for high resolution 2-D spectrum estimation" | | TECHNICAL FIELDS SEARCHED (Int. Cl.5) G 01 R |
| A | ICASSP '88, V & E VOLUME IV VLSI SPECTRAL ESTIMATION, 1988 INTERNATIONAL CONFERENCE ON ACOUSTICS, SPEECH, AND SIGNAL PROCESSING, New York, 11th - 14th April 1988, pages 2468-2471, IEEE, New York, US; M. DENDRINOS et al.: "Spectrum analysis using a new auto-correlation measure" | | |

The present search report has been drawn up for all claims

| Place of search | Date of completion of search | Examiner |
|---|---|---|
| The Hague | 13 January 91 | HOORNAERT W. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

&: member of the same patent family, corresponding document